(19) Europäisches Patentamt
European Patent Office
Office européen des brevets

(11) **EP 1 109 423 A1**

(12) **EUROPEAN PATENT APPLICATION**
published in accordance with Art. 158(3) EPC

(43) Date of publication:
**20.06.2001 Bulletin 2001/25**

(51) Int Cl.[7]: **H05B 3/28**, H05B 3/12

(21) Application number: **99923983.3**

(86) International application number:
**PCT/JP99/03086**

(22) Date of filing: **09.06.1999**

(87) International publication number:
**WO 00/76273 (14.12.2000 Gazette 2000/50)**

(84) Designated Contracting States:
**DE FR GB IE IT NL**

(71) Applicant: **IBIDEN CO., LTD.**
**Ogaki-shi Gifu-ken 503-0917 (JP)**

(72) Inventors:
• **FURUKAWA, Masakazu, Ibiden Co., Ltd.**
**Ibi-gun, Gifu 501-0601 (JP)**

• **HIRAMATSU, Yasuji, Ibiden Co., Ltd.**
**Ibi-gun, Gifu 501-0601 (JP)**
• **ITO, Yasutaka, Ibiden Co., Ltd.**
**Ibi-gun, Gifu 501-0601 (JP)**

(74) Representative: **Grünecker, Kinkeldey,**
**Stockmair & Schwanhäusser Anwaltssozietät**
**Maximilianstrasse 58**
**80538 München (DE)**

(54) **CERAMIC HEATER AND METHOD FOR PRODUCING THE SAME, AND CONDUCTIVE PASTE FOR HEATING ELEMENT**

(57) It is to provide a ceramic heater being easy in temperature control, thin and light as well as an electrically conductive paste for the formation of a heating body used in the heater, and is characterized in that a heating body formed by sintering metal particles and, if necessary, a metal oxide is arranged on a surface or an inside of a ceramic substrate comprised of a nitride ceramic or carbide ceramic.

And also, a paste formed by mixing metal particles and a metal oxide is used as the electrically conductive paste.

# FIG.2

**Description**

TECHNICAL FIELD

This invention relates to a ceramic heater used for drying in a semiconductor industry, and more particularly to a ceramic heater facilitating temperature control and being thin and light and a method of producing the same as well as an electrically conductive paste used for the formation of a heating element of the heater.

BACKGROUND ART

Typical semiconductor products are manufactured by applying an etching resist onto a silicon wafer and then etching it. In this case, a photosensitive resin applied onto the surface of the silicon wafer should be dried after the application. As a drying method, it is general to place the silicon wafer coated with the resin on a heater and then conduct the heating.

As such a heater, it has typically been used to attach a heating body to a back surface of an aluminum substrate. However, such a metallic heater has problems as mentioned below.

That is, the substrate of the heater itself is a metal, so that the thickness of the substrate should be made to about 15 mm. Because, strain is caused in the thin metal plate due to thermal expansion resulted from the heating and hence the wafer placed on the metal plate is broken or tilted. Therefore, the conventional metal heater has problems that the weight is heavy and the volume is bulky.

And also, the heating of the silicon wafer by the heater is carried out by adjusting voltage and current applied to the heating body to control the temperature of the substrate. However, this method has a problem that since the metal plate is thick, the temperature of the heater substrate does not rapidly follow to the change of the voltage or current and the temperature control property is bad.

A primary object of the invention is to provide a heater easily conducting the temperature control and being thin and light as well as a method of producing the same.

Another object of the invention is to provide an electrically conductive paste for a heating body having excellent heat generating properties.

DISCLOSURE OF THE INVENTION

As a result of examinations on the above problem included in the conventional technique, the inventors noticed that a ceramic material having an excellent heat conductivity, particularly nitride ceramic or carbide ceramic is used as a substrate for a heater instead of the metal such as aluminum or the like. There is found out a discovery that such a ceramic substrate does not cause warping or strain even when it is made thin and can rapidly and easily conduct the temperature control and particularly it is excellent in the responsibility when the temperature control is carried out by changing a voltage or current applied to the heating body. And also, the inventors have found that an electrically conductive paste containing metal particles has generally a property of hardly adhering to the nitride ceramic or carbide ceramic, but when a metal oxide is added to the electrically conductive paste, the adhesion property is improved through the sintering of the metal particles.

Under the above knowledge, the invention has been developed and the construction thereof is as follows:

1. The invention is a ceramic heater comprising a ceramic substrate made of a nitride ceramic or a carbide ceramic and a heating body arranged on a surface thereof.
2. The heating body is preferably arranged so as to embed a part thereof in the ceramic substrate.
3. The heating body is favorable to be made of a sintered body of metal particles.
4. The heating body is favorable to be made of the metal particles and at least one metal oxide selected from the group consisting of lead oxide, zinc oxide, silicon oxide, boron oxide, aluminum oxide, yttrium oxide and titanium oxide.
5. As the metal particles, it is favorable to use one or more of noble metal, lead, tungsten, molybdenum and nickel.
6. The heating body is favorable to be covered on its surface with a non-oxidizing metal layer.
7. The heating body is favorable to have a sectional shape that an aspect ratio at section (width of heating body/thickness of heating body) is 10-10000.
8. It is characterized in that a flat heating body having an aspect ratio at section (width of heating body/thickness of heating body) of 10~10000 is arranged in an inside of a ceramic substrate made of the nitride ceramic or carbide ceramic.
9. The invention is a ceramic heater comprising a ceramic substrate made of a nitride ceramic or a carbide ceramic and a flat heating body arranged in an inside thereof, wherein an arranging position of the heating body is a position eccentrically arranged from a center of the substrate in a thickness direction thereof and a face far apart from the heating body is a heating face. This heater is also favorable to have features of the above items 2-8.

10. The heating body is favorable to be made of a sintered body of metal particles or electrically conductive ceramic.

11. The heating body is favorable to be tungsten, molybdenum, tungsten carbide or molybdenum carbide.

12. The eccentric degree of the heating body is favorable to be a position from the heating face of the substrate to more than 50% but less than 100%.

13. The heating body is favorable to have an aspect ratio at section (width of heating body/thickness of heating body) of 10~10000.

14. The invention also proposes a method of producing a ceramic heater which comprises at least following steps ①~③

① step of sintering nitride ceramic powder or carbide ceramic powder to form a substrate made of nitride ceramic or carbide ceramic;
② step of printing an electrically conductive paste on the substrate; and
③ step of sintering the electrically conductive paste by heating to form a heating body on the surface of the ceramic substrate.

15. It is preferable to adopt a step of plating a non-oxidizing metal onto the surface of the resulting heating body to form a metal coating layer as a post step of the step ③.

16. It is preferable to use a mixed paste of metal particles and metal oxide as the electrically conductive paste used in the step ③.

17. Furthermore, the invention proposes a method of producing a ceramic heater which comprises at least following steps ①~④

① step of shaping nitride ceramic powder or carbide ceramic powder to form a green sheet made of nitride ceramic or carbide ceramic;
② step of printing an electrically conductive paste of metal particles alone or a mixture with a metal oxide thereof on the surface of the green sheet made of the nitride ceramic or carbide ceramic;
③ step of laminating the green sheet printed with the electrically conductive paste on one or more of another green sheet obtained by the same treatment as in the step ①; and
④ step of sintering the green sheets and the electrically conductive paste by heating under pressure.

18. It is favorable that when the green sheets obtained by the same treatment as in the step ①are laminated on the upper side and lower side of the green sheet printed with the electrically conductive paste in the step ② the number ratio of the upper and lower green sheets is adjusted to 1/1 to 1/99.

19. Moreover, the invention proposes an electrically conductive paste for a heating body of a ceramic heater comprising metal particles and a metal oxide.

20. As the metal particles, it is favorable to use one or more of noble metal, lead, tungsten, molybdenum and nickel.

21. As the metal oxide, it is favorable to use one or more of lead oxide, zinc oxide, silicon oxide, boron oxide, aluminum oxide, yttrium oxide and titanium oxide.

22. As the electrically conductive paste, it is favorable to use a paste formed by mixing more than 0.1 wt% but less than 10 wt% of the metal oxide with the metal particles.

23. The metal particle is favorable to have an average particle size of 0.1~100 μm.

24. The metal particles are favorable to be flake-shaped particle or a mixture of spherical particle and flake-shaped particle.

BRIEF DESCRIPTION OF THE DRAWINGS

Fig. 1 is a plan view of a ceramic heater according to the invention;
Fig. 2 is a section view illustrating a use state of a ceramic heater according to the invention;
Fig. 3 is a diagrammatic view illustrating a production method of a ceramic heater according to the invention;
Fig. 4 is a diagrammatic view illustrating a state of connecting a terminal pin to a hole for through-hole;
Fig. 5 is a diagrammatic view illustrating another production method of a ceramic heater according to the invention; and
Fig. 6 is a diagrammatic view illustrating the other production method of a ceramic heater according to the invention.

BEST MODE FOR CARRYING OUT THE INVENTION

The ceramic heater according to the invention is a heater wherein a ceramic substrate made of an insulative nitride ceramic or carbide ceramic is used and a heating body is formed on one surface of the ceramic substrate by printing and the other surface thereof is used as a heating face heating a semiconductor product such as silicon wafer or the like placed thereon.

In the ceramic heater according to the invention, a heating body having a flat sectional shape may be disposed in an inside of the ceramic substrate (sandwiched therebetween), wherein the heating body is eccentrically arranged from a center in a thickness direction of the substrate and a face apart away from the heating body is used as a heating face.

The nitride ceramic or carbide ceramic constituting the substrate is small in the thermal expansion coefficient as compared with the metal and has a property that warping or distortion is not caused by heating even when it is made thin. Therefore, the substrate for the heater can be made thin and light.

And also, such a ceramic substrate is high in the thermal conductivity and thin, so that the surface temperature of the substrate rapidly follows to the temperature change of the heating body. That is, when the temperature of the heating body is changed by varying the voltage or current, the surface temperature of the ceramic substrate is changed while rapidly following to such a change.

In the ceramic heater according to the invention, a side of the substrate opposite to the side facing the heating body is a heating face, or a side of the substrate apart away from the heating body eccentrically arranged from the center of the substrate in the thickness direction is a heating face, so that the propagation of heat is uniformly and rapidly diffused over a whole of the substrate, whereby the occurrence of temperature distribution in the heating face restricted by the pattern of the heating body can be controlled and hence the distribution of the heating temperature can be made uniform.

In this connection, USP 5,643,483 discloses a technique that one surface of a quartz substrate is roughened and coated with a platinum-palladium paste to form a heating body and a wafer is placed on a surface of the substrate opposite to the heating body for heating. And also, USP 5,668,524 discloses a ceramic heater provided with a chuck embedding a heater therein. Further, USP 5,566,043 discloses a heater formed by placing a heating body of a thermally decomposed graphite on a surface of a boron nitride substrate.

In USP 5,643,483, however, a quartz substrate is used and the heating body is made from a platinum-palladium paste, but the oxide as defined in the invention is not mixed with the paste, so that the heating body can not be formed unless the substrate is roughened.

In USP 5,668,524, the heating body is not eccentrically arranged and also concrete shape such as aspect ratio or the like is not disclosed. Therefore, the uniformity of temperature on the heating face is poor.

In USP 5,566,043, the heating body of thermally decomposed graphite is used, so that when it is heated in air above 500°C, the heating body itself is burnt out and hence the range of service temperature is restricted.

Thus, the invention is entirely different from the above conventional techniques.

In the invention, the ceramic substrate is favorable to have a thickness of about 0.5∼5 mm. Because, when the thickness is too thin, the substrate is apt to be broken.

As the nitride ceramic being a material of the ceramic substrate, it is desirable to use at least one metal nitride ceramic selected from the group consisting of aluminum nitride, silicon nitride, titanium nitride and the like. On the other hand, as the carbide ceramic, it is desirable to use at least one metal carbide ceramic selected from the group consisting of silicon carbide, zirconium carbide, titanium carbide, tungsten carbide and the like. Among these ceramics, aluminum nitride is preferable. Because thermal conductivity of aluminum nitride is as highest as 180 W/m.K.

Further, the heating body arranged on the ceramic substrate is formed by sintering metal particles or metal oxide particles in the electrically conductive paste. These particles can be baked on the surface of the ceramic substrate by sintering under heating. Moreover, the sintering treatment is carried out to an extent that the metal particles or the metal particle and ceramic are fused to each other.

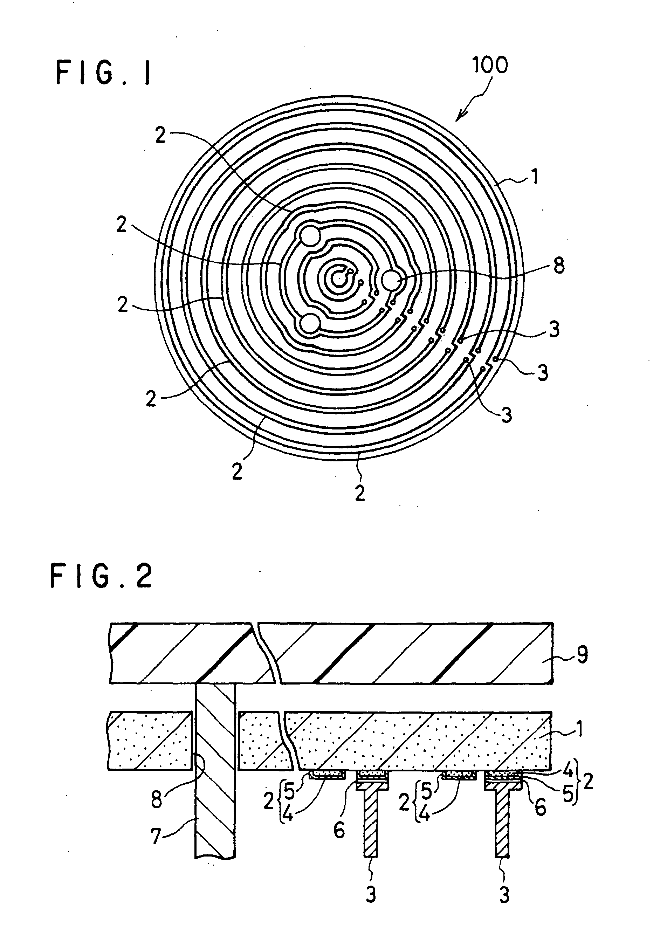

Then, the heating body 2 is preferably a concentrically shaped pattern as shown in Fig. 1 because it is required to uniformly raise the temperature of the ceramic substrate 1 as a whole. The patterned heating body 2 is desirable to have a thickness of about 1-50 μm, and when the heating body 2 is formed on the surface of the substrate 1, the thickness is favorable to be 1∼10 μm. On the other hand, when the heating body is formed in the inside of the substrate 1, the thickness is favorable to be 1∼50 μm.

And also, the heating body is desirable to have a width of about 0.1-20 mm, but when the heating body 2 is formed on the surface of the substrate 1, the width is favorable to be 0.1∼5 mm, and when the heating body 2 is formed in the inside of the substrate 1, the width is favorable to be 1-20 mm. The reason on these limitations is due to the fact that the resistance value can be changed by varying the thickness and width of the heating body 2 but the above ranges are most effective to the temperature control of the heating body. Moreover, the resistance value of the heating body 2 becomes larger as the body becomes thin and fine.

Furthermore, the thickness and width can be made large when the heating body 2 is formed in the inside of the substrate 1. Because, when the heating body 2 is arranged in the inside, a distance between the heating face and the heating body becomes short and the temperature uniformity of the heating face of the ceramic substrate 1 lowers, so that in order to uniformly heat the heating face, it is required to widen the width of the heating body 2 itself. On the other hand, when the heating body is arranged in the inside, it is needless to consider the adhesion property to the nitride ceramic of the substrate or the like, so that a high melting point metal such as tungsten, molybdenum or the like, and carbides of tungsten or molybdenum can be used and hence the resistance value can be increased. As a result, the thickness of the heating body can be thickened for preventing the breakage or the like.

The heating body is generally rectangular or ellipsoidal at its section, but it is desirable to be a flat shape. Particularly, when the heating body is arranged in the inside of the ceramic substrate 1, it is essential to be flat. Because, the flat sectional shape is easy to dissipate heat toward the heating face and hence the temperature distribution is hardly caused in the heating face.

The aspect ratio at the section of the heating body 2 (width of the heating body/thickness of the heating body) is desirably about 10~10000, preferably 50~5000. When the aspect ratio is adjusted to the above range, the resistance value of the heating body 2 can be increased and at the same time, the uniformity of the temperature distribution in the heating face can be ensured.

When the thickness of the patterned heating body 2 arranged on the surface of the ceramic substrate 1 or inside thereof is constant, if the aspect ratio is small, the transmission quantity of heat directing to the heating face of the substrate becomes small and the heating face has the same heat distribution as in the patterned heating body. Inversely, if the aspect ratio is too large, the temperature in a portion just above the center of the patterned heating body becomes higher and finally the same heat distribution as in the patterned heating body is formed in the heating face. Considering such a temperature distribution, the aspect ratio at the section of the heating body 2 (width of the heating body/thickness of the heating body) is desirable to be within a range of 10~10000.

This is due to the fact that when the aspect ratio of the heating body 2 is made to 50~5000, cracking or peeling due to thermal shock hardly occurs.

Moreover, when the heating body 2 is formed in the inside of the ceramic substrate 1, the aspect ratio can be made large. However, in case of forming the heating body 2 in the inside, the distance between the heating face and the heating body becomes short and the uniformity of the surface temperature lowers, so that the heating body itself is necessary to be flat shape.

In the invention, when the heating body 2 is arranged in the inside of the ceramic substrate 1, the arranging position of the heating body in the thickness direction can be made eccentric, but it is desirable that the eccentric degree is a position from a surface of the substrate (heating face) to more than 50% but less than 100% because the temperature distribution of the heating face is prevented and the occurrence of warping in the ceramic substrate can be controlled. It is preferably 55~95%.

And also, when the heating body 2 is formed in the inside of the ceramic substrate 1, the layer forming the heating body may be divided into plural stages. In this case, it is desirable that the patterns of the divided layers are formed so as to supplement with each others to thereby render into a state that complete pattern is formed in any layers viewed from the heating face. For example, there is a structure that the upper layer and the lower layer are arranged in a checkered pattern to form a complete pattern as a whole.

Further, when the heating body 2 is arranged on the surface of the ceramic substrate 1, it is desirable that a part of the heating body (bottom portion) is embedded in the ceramic substrate. Such an arrangement of the heating body can simultaneously realize the improvement in the resistance control of the heating body and the improvement in the adhesion property to the ceramic substrate.

There is described an electrically conductive paste used for the formation of the heating body on the ceramic substrate below. The electrically conductive paste is usual to be metal particle or electrically conductive ceramic ensuring electrical conductivity, or a mixture with a resin, a solvent, a tackifier and the like.

As the metal particle, use may be made of one or more selected from noble metal (gold, silver, platinum, palladium), lead, tungsten, molybdenum and nickel. These metals are not relatively oxidized and show a sufficient resistance to heating. As the electrically conductive ceramic, use may be made of one or more selected from carbides of tungsten or molybdenum and so on.

These metal particles or electrically conductive ceramic are desirable to have a particle size of 0.1~100 μm. When the particle size is too small, the oxidation is easily caused, while when it is too large, the sintering is hardly conducted and the resistance value becomes large.

The metal particles can be used in a spherical shape, a flake-shape or a mixture of spherical shape and flake-shape. Particularly, when the shape is flake, a metal oxide mentioned below is easily held between the metal particles and the adhesion property between the heating body and the nitride ceramic or the like is improved.

As the resin used in the electrically conductive paste, epoxy resin, phenolic resin or the like is favorable. As the solvent, isopropyl alcohol or the like may be used. As the tackifier, cellulose or the like may be used.

And also, a metal oxide is further included in the electrically conductive paste in addition to the metal particles, which is effective to form a sintered mixture body of the metal particles and the metal oxide as a heating body. That is, when the metal oxide is interposed between the nitride ceramic or carbide ceramic and the metal particle, the adhesion property can be improved. Although the reason of improving the adhesion property is not clear, an oxide film is slightly existent on the surface of the metal particle or the surface of the nitride ceramic or carbide ceramic, so that it is guessed that the oxide film shows an affinity with the metal oxide and is easily united therewith and hence the metal particles adhere to the nitride ceramic or carbide ceramic through the oxide.

As the metal oxide, use may be made of one or more selected from lead oxide, zinc oxide, silicon oxide, boron oxide, aluminum oxide, yttrium oxide and titanium oxide. These oxides can improve the adhesion property between the metal particle and the nitride ceramic or carbide ceramic without increasing the resistance value of the heating body.

The addition amount of the metal oxide is desirable to be 0.1-less than 10 wt% to the metal particle. When the amount is less than 0.1 wt%, the addition effect is not obtained, while when it is not less than 10 wt%, the resistance value of the heating body 2 is too large.

Moreover, the mixing ratio of these metal oxides is desirable to adjust so that when the total amount of the metal oxides is 100 wt%, lead oxide is 1-10 wt%, silicon oxide is 1-30 wt%, boron oxide is 5~50 wt%, zinc oxide is 20-70 wt%, aluminum oxide is 1~10 wt%, yttrium oxide is 1-50 wt% and titanium oxide is 1-50 wt% and the total thereof does not exceed 100 wt%. These ranges are particularly effective to improve the adhesion property between the metal particle and the nitride ceramic.

Thus, when the addition amount of the metal oxide is adjusted to be within a range of 0.1-less than 10 wt% per the metal particle, the area resistance of the heating body can be made 1-45 m$\Omega$/$\square$. As the area resistance becomes too large, the amount of heat generation to an applied voltage is too large and the control is difficult in case of arranging the heating body on the surface of the ceramic substrate. Moreover, when the amount of the metal oxide is not less than 10 wt%, the area resistance exceeds 50 m$\Omega$/$\square$ and the amount of heat generation is too large and the temperature control is difficult and the uniformity of the temperature distribution in the heater lowers.

Although the resisting body for the heater has hitherto been considered to be unsuitable unless the area resistance is not less than 50 m$\Omega$/$\square$ (JP-A-4-300249), according to the invention, the area resistance is inversely made to not more than 45 m$\Omega$/$\square$ to facilitate the temperature control and ensure the uniformity of the temperature distribution.

As another embodiment of the invention, it is desirable to cover the surface of the heating body with a metal layer. Since the heating body is a sintered body of metal particles as mentioned above, when it is exposed in air, it is easily oxidized to change the resistance value. Now, the oxidation is prevented by covering the surface of the metal particle sintered body with the metal layer. The thickness of the metal layer is desirable to be about 0.1~10 $\mu$m. Because it is the range capable of preventing the oxidation of the heating body without changing the resistance value of the heating body.

The metal coated on the surface of the metal particle sintered body may be a non-oxidizing metal. For example, it may be one or more selected from gold, silver, palladium, platinum and nickel. Among them, nickel is favorable. Because, the heating body is generally required to have a terminal for connecting to a power source and the terminal is attached to the heating body through a solder, but nickel has an action of preventing the thermal diffusion of the solder. As a connection terminal, there can be used a terminal pin made of Kovar.

However, when the heating body is arranged in the inside of the ceramic substrate, the surface of the heating body is not oxidized, so that the covering is useless.

As the solder, use may be made of solder alloys such as silver-lead, lead-bismuth, bismuthtin and the like. The thickness of the solder layer is sufficiently within a range of 0.1-50 $\mu$m for ensuring the connection through the solder.

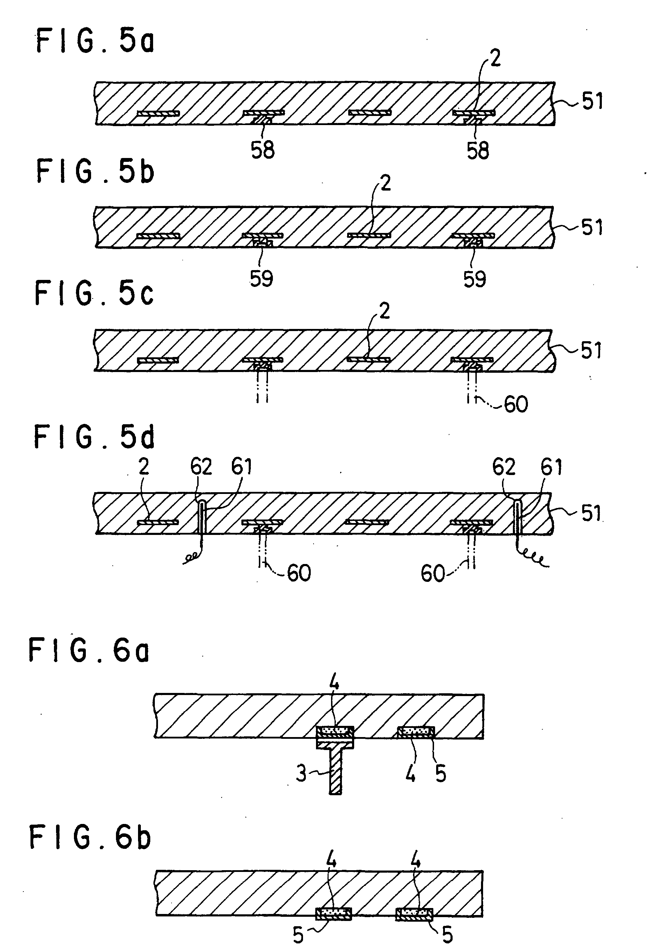

In the invention, as shown in Fig. 5(d), a thermocouple 61 may be embedded in the ceramic substrate 1, if necessary. The thermocouple 61 measures a temperature of the ceramic substrate 1 and adjusts voltage and current based on the measured data, whereby the temperature of the heating face of the ceramic substrate 1 can be controlled easily and accurately.

Fig. 2 is a partial section view illustrating a use state of the ceramic heater according to the invention. Numeral 3 is a terminal pin, numeral 4 a metal (Ag-Pb) particle sintered body, numeral 5 a metal (Ni) covering layer. and a heating body 2 is constituted with 4 and 5. And also, numeral 6 is a solder layer, and the terminal pin is attached through the solder layer.

Furthermore, a plurality of through-holes 8 are formed in the ceramic substrate 1, and a support pin 7 for a semiconductor wafer is inserted into the through-hole 8, and a semiconductor wafer 9 is attached to a top of the pin 7 protruding onto the ceramic substrate 1 adjacent thereto or at a slight space. In this case, the semiconductor wafer 9 is delivered onto a transferring machine (not shown) or the semiconductor wafer 9 is received from the transferring machine by lifting up and down the support pin 7.

The production method of the ceramic heater according to the invention will be described below.

A. In case of forming the heating body on the surface of the ceramic substrate (Fig. 2)

(1) Step of sintering powder of insulative nitride ceramic or insulative carbide ceramic to form a plate-shaped body of nitride ceramic or carbide ceramic (ceramic substrate).

In this step, powder of nitride ceramic such as aluminum nitride and the like or carbide ceramic such as silicon carbide and the like, or a mixed powder with a sintering aid such as yttria or the like and a binder, if necessary, is rendered into granules by a method such as spray-drying method or the like and the resulting granules are placed in a mold or the like and shaped into a plate by pressing to form a green shaped body.

If necessary, a through-hole 8 for inserting a support pin 7 for semiconductor wafer and a recess portion 62 embedding a thermocouple 61 therein are formed in the green shaped body.

Then, the green shaped body is sintered by heating and firing to produce a ceramic plate-shaped body. In the heating and firing, a ceramic substrate for heater having no pore is produced by pressing. The heating and firing may be conducted above a sintering temperature, but 1000-2500°C is favorable in the nitride ceramic or carbide ceramic.

(2) Step of printing an electrically conductive paste containing metal particles on the surface of the ceramic plate-shaped body obtained in the step (1) (heater plate or ceramic substrate) to form a metal particle layer 4.

In this step, the electrically conductive paste comprised of metal particles, resin and solvent and having a high viscous fluidity is printed at a given position by a method such as screen printing or the like. The reason why the electrically conductive paste is applied by printing to form the metal particle layer 4 is due to the fact that it is desirable to accurately form a pattern of concentric circles as shown in Fig. 1 for the formation of a heating body 2 for heating a whole of the ceramic substrate at a uniform temperature.

And also, the sectional shape of the heating body is rectangular as a base and is desirable to be a flat sectional shape.

(3) Step of sintering the metal particle layer formed by printing on the ceramic substrate under heating to form the heating body 2 on the surface of the ceramic substrate 1.

The metal particle layer formed by printing of the electrically conductive paste is heated and fired to remove the resin and the solvent and sinter the metal particles (the heating-firing temperature is 500~1000°C). In this connection, for example, when a metal oxide is added to the electrically conductive paste, the metal particles, ceramic plate-shaped body and metal oxide are integrally united by sintering, so that the adhesion property between the heating body and the ceramic plate-shaped body is improved.

(4) Further, a metal covering layer is formed on the surface of the metal particle layer 4, if necessary. This treatment can be carried out by electrolytic plating, electroless plating, sputtering or the like, but the electroless plating is most suitable considering mass production.

(5) Onto an end portion of the pattern of the thus obtained heating body is attached a terminal pin 3 for the connection to a power source through a solder.

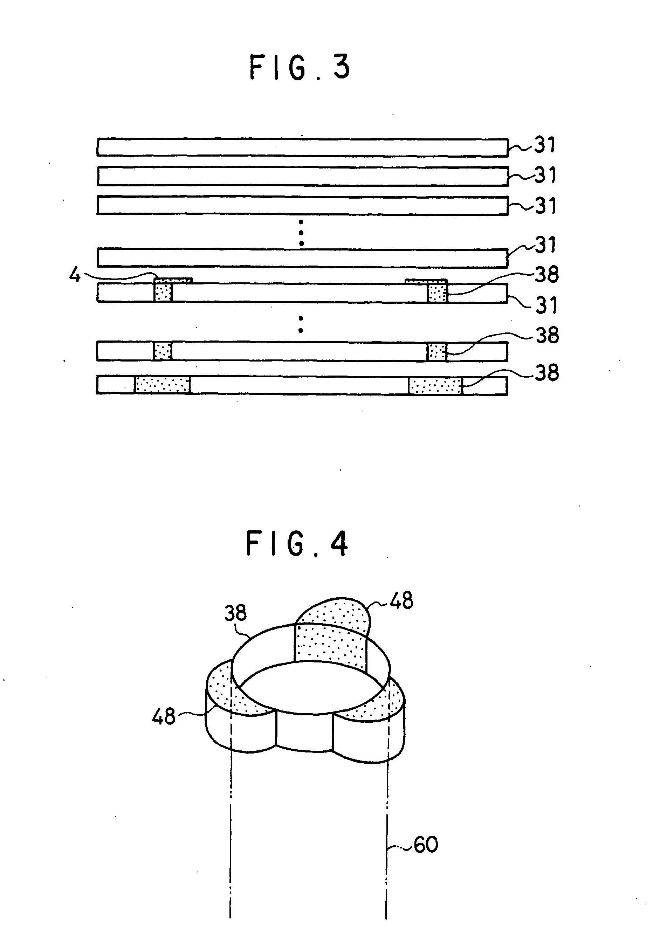

B. In case of forming the heating body in the inside of the ceramic substrate (Fig. 3)

(1) Ceramic powder such as nitride ceramic, carbide ceramic or the like is mixed with a binder and a solvent to obtain a green sheet 31.

As the ceramic powder, use mkay be made of aluminum nitride, silicon carbide and the like, and if necessary, a sintering aid such as yttrium oxide (yttria) or the like may be added. As the binder, at least one selected from acrylic binder, ethyl cellulose, butyl cellosolve and polyvinyral is desirable. As the solvent, it is desirable to use one or more selected from a-terpineol and glycol.

A paste obtained by mixing them is shaped into a sheet by a doctor blade method to produce a green sheet 31. In the thus obtained green sheet may be formed a through-hole 8 for inserting a support pin 7 for silicon wafer or a recess portion 62 for embedding a thermocouple 61, if necessary. The through-hole 8 or recess portion 62 is formed by punching or the like.

The green sheet has a thickness of about 0.1~5 mm.

(2) Then, a metal particle layer as a heating body is printed on the green sheet.

The metal particle layer 4 as a heating body is formed by printing a metal paste or an electrically conductive paste using an electrically conductive ceramic.

Such a paste contains the metal particles or electrically conductive ceramic particles therein. As the metal particle, tungsten or molybdenum is optimum, and as the electrically conductive ceramic particle, a carbide of tungsten or molybdenum is optimum. Because they are hardly oxidized and are less in the lowering of thermal conductivity.

The tungsten particles or molybdenum particles have an average particle size of 0.1-5 μm. When the size is too large or too small, the printing of the electrically conductive paste is difficult. As the electrically conductive paste, it is optimum to use tungsten paste or molybdenum paste prepared by mixing 85-97 parts by weight of the metal particle or the electrically conductive ceramic particle, 1.5-10 parts by weight of at least one binder selected from acrylic binder, ethyl cellulose, butyl cellosolve and polyvinyral and 1.5-10 parts by weight of at least one solvent selected from a-terpineol and glycol.

(3) Next, the green sheet 31 printed with the heating body 2 in the step (2) and another green sheet 31 obtained by the same method as in the step (1) are laminated.

In the illustrated embodiment, 37 sheets are laminated on an upper surface of the metal particle layer 4 (heating face side) and 17 sheets are laminated on an opposite side. That is, the forming position of the heating body 2 is made eccentric in a thickness direction by making the number of green sheets (1) laminated on the upper side (heating face side) of the heating body (2) printed green sheet larger than the number of green sheets laminated on the lower side. Desirably, the ratio of upper side to lower side is rendered into $1/1\sim1/99$ by laminating the great number of green sheets having the same thickness. Concretely, $20\sim50$ sheets are laminated on the upper side, and $5\sim20$ sheets are laminated on the lower side.

(4) The green sheets and electrically conductive paste are sintered by heating and pressing. The heating temperature is 1000-2000°C, and the pressing is carried out at 100-200 kg/cm$^2$ un an inert gas atmosphere. As the inert gas, use may be made of argon, nitrogen and the like.

Finally, a solder paste is printed on a portion to be attached with a terminal pin 3, and thereafter a terminal pin 3 is placed and fixed by reflowing under heating. The heating temperature for reflowing the solder paste is preferably 200-500°C. Further, a thermocouple may be embedded, if necessary.

EXAMPLES

(Example 1) Heater made of aluminum nitride ceramic substrate

(1) A mixed composition of 100 parts by weight of aluminum nitride powder (average particle size 1.1 μm), 4 parts by weight of yttria (average particle size 0.4 μm), 12 parts by weight of an acryl binder and alcohol is rendered into granulated powder by a spray drying method.

(2) The granulated powder is placed in a mold and shaped into a flat plate to obtain a green shaped body. The green shaped body is drilled to from a through-hole 8 for inserting a support pin for semiconductor wafer and a recess portion (not shown) for embedding a thermocouple.

(3) The green shaped body is hot pressed at 1800°C under a pressure of 200 kg/cm$^2$ to obtain an aluminum nitride plated body having a thickness of 3 mm. It is cut out into a disc having a diameter of 210 mm to form a ceramic plated body (ceramic substrate) 1.

(4) An electrically conductive paste is printed on the ceramic substrate 1 obtained in the item (3) by screen printing. The printed pattern is a concentric circle pattern as shown in Fig. 1. As the electrically conductive paste is used Solvest PS 603D, trade name, made by Tokuriki Kagaku Kenkyusho, which is used for the formation of through-hole in a printed wiring board. This electrically conductive paste is a silver/lead paste and contains 7.5 wt% of a metal oxide being a mixture of lead oxide, zinc oxide, silica, boron oxide and alumina (weight ratio of 5/55/10/25/10) per the amount of silver. Moreover, a flake having an average particle size of 4.5 μm is used as silver.

(5) The ceramic substrate printed with the electrically conductive paste is heated and fired at 780°C to sinter silver and lead in the electrically conductive paste and bake the ceramic substrate 1. The pattern of silver-lead sintered body 4 has a thickness of 5 μm, a width of 2.4 mm and an area resistivity of 7.7 mΩ/□

(6) The ceramic substrate 1 of the item (5) is immersed in an electroless nickel plating bath comprised on an aqueous solution of 80 g/1 of nickel sulfate, 24 g/1 of sodium hypophosphite, 12 g/1 of sodium acetate, 8 g/l of boric acid and 6 g/1 of ammonium chloride to precipitate a nickel layer having a thickness of 1 μm on the surface of the silver-lead sintered body 4, whereby a heating body 2 is formed.

(7) A silver-lead solder paste is printed on a terminal attaching portion for ensuring connection to a power source by screen printing 1 to form a solder layer (made by Tanaka Kinzoku K.K.) 6. Then, a terminal pin 3 of Kovar is placed on the solder layer 6 and reflowing is carried out by heating at 420°C to fix the terminal pin 3 to the surface of the heating body 2.

(8) A thermocouple for temperature control (not shown) is embedded to obtain a heater 100 (Figs. 1 and 2).

(Example 2) Heater of silicon carbide ceramic substrate

The basically same steps as in Example 1 are repeated except that silicon carbide powder having an average particle size of 1.0 µm is used, and the sintering temperature is 1900°C, and the surface is fired at 1500°C for 2 hours to form $SiO_2$ layer having a thickness of 1 µm on the surface.

(Example 3)

With respect to the heaters of Examples 1 and 2, followability of temperature in the heating face of the ceramic substrate to change of voltage or current and pull strength of the heating body 2 are measured. That is, when the voltage is applied to each heater, the temperature change is observed in 0.5 second in the heater of Example 1, and the temperature change is observed in 2 seconds in the heater of Example 2. On the other hand, the pull strength of the heating body 2 is 3.1 kg/mm$^2$ in the heater of Example 1 and 3 kg/mm$^2$ in the heater of Example 2.

(Example 4) Heater provided in its inside with a heating body (Figs. 3, 5)

(1) A mixed composition of 100 parts by weight of aluminum nitride powder (made by Tokuyama Co., Ltd. average particle size 1.1 µm), 4 parts by weight of yttria (average particle size 0.4 µm), 11.5 parts by weight of acryl binder, 0.5 part by weight of a dispersing agent and 53% by weight of a mixed alcohol of 1-butanol and ethanol is shaped with a doctor knife to obtain a green sheet 31 having a thickness of 0.47 mm.
(2) The green sheet 31 is dried at 80°C for 5 hours, and a through-hole for inserting a support pin for semiconductor wafer and a through-hole 38 for the connection between a heating body and a terminal pin having diameters of 1.8 mm, 3.0 mm and 5.0 mm are formed by punching.
(3) An electrically conductive paste A is prepared by mixing 100 parts by weight of tungsten carbide particles having an average particle size of 1 µm, 3.0 parts by weight of acrylic binder, 3.5 parts by weight of α-terpineol and 0.3 part by weight of a dispersing agent.
And also, an electrically conductive paste B is prepared by mixing 100 parts by weight of tungsten carbide particles having an average particle size of 3 µm, 1.9 parts by weight of acrylic binder, 3.7 parts by weight of a-terpineol and 0.2 part by weight of a dispersing agent.
The electrically conductive paste A is printed on the green sheet 31 in a pattern form by screen printing. The printed pattern is concentric circles as shown in Fig. 1. And also, the electrically conductive paste B is filled in the through-hole 38 for connecting to the terminal pin.
Further, 37 green sheets 31 not printed with the electrically conductive paste A are laminated on upper side (heating face) and 17 green sheets 31 are laminated on lower side, which are united at 130°C under a pressure of 80 kg/cm$^2$ to obtain a laminate (Fig. 3).
(4) The laminate is degreased in a nitrogen gas at 600°C for 5 hours and hot pressed at 1890°C under a pressure of 150 kg/cm$^2$ for 3 hours to obtain an aluminum nitride plate-shaped body having a thickness of 3 mm. It is cut out into a disc having a diameter of 230 mm to provide a ceramic substrate 51 having a heating body of 6 µm in thickness and 10 mm in width therein (Fig. 5(a)).
(5) The ceramic substrate 51 of the item (4) is polished with diamond grindstone and a mask is placed thereon, which is subjected to blast treatment with glass beads to form a hole 62 for housing a thermocouple (Fig. 5(d)).
(6) Further, a part of the surface of the through-hole 38 is enlarged to form a recess portion 48 as shown in Fig. 4, and a gold solder consisting of Ni-Au alloy is supplied to the recess portion 48 and reflowed by heating at 700°C to connect a terminal pin 60 of Kovar (Fig. 5(c)).
Moreover, the connection of the terminal pin 60 is rendered into a three point support utilizing the recess portion 48, which is desirable to ensure the connection reliability of the terminal pin 60.
(7) A plurality of thermocouples 61 for the temperature control are embedded in the hole 62 to obtain a ceramic heater (Fig. 5(d)).

(Comparative Example 1) Heater of aluminum plate

A nickel-chromium wire supported by silicone rubber is used as a heating body and sandwiched between an aluminum plate having a thickness of 15 mm and a support plate and fixed by bolts to form a heater. When a voltage is applied to this heater, 24 seconds is required for the observation of temperature change.

(Comparative Example 2) Alumina heater

The same procedure as in Example 1 is fundamentally repeated except that a composition comprising 100 parts by weight of alumina powder (average particle size 1.0 µm), 12 parts by weight of acryl binder and alcohol is granulated by a spray drying method and placed in a mold and shaped into a flat plate to form a green sheet and then the green sheet is hot pressed at 1200°C under a pressure of 200 kg/cm$^2$ to obtain an alumina substrate having a thickness of 3 mm.

And also, an electrically conductive paste is prepared by mixing 100 parts by weight of tungsten particles having an average particle size of 3 μm, 1.9 parts by weight of acrylic binder, 3.7 parts by weight of a-terpineol and 0.2 part by weight of dispersing agent and printed. The ceramic substrate printed with the electrically conductive paste is fired by heating at 1000°C to sinter tungsten.

(Example 5)

The same procedure as in Example 4 is fundamentally repeated except that the heating body is not flat but is a square of 20 μm in thickness x 20 μm in width at section (aspect ratio of 1).

(Example 6)

The same procedure as in Example 4 is fundamentally repeated except that the printing conditions are changed and the heating body is not flat but is 5 μm in thickness x 72 mm in width at section (aspect ratio of 12000).

(Example 7)

The same procedure as in Example 4 is fundamentally repeated except that 24 green sheet are laminated on upper side of the green sheet printed with the electrically conductive paste and 25 green sheets are laminated on lower side thereof and the heating body is located in a center of the ceramic substrate.

(Example 8)

The same procedure as in Example 1 is fundamentally repeated except that an electrically conductive paste having the following composition is prepared instead of Solvest PS603D.

Silver powder spherical, average particle size of 5.0 μm, 100 parts by weight

Metal oxide (weight ratio of lead oxide, zinc oxide, silica, boron oxide and alumina of 5/55/10/25/5) 7.5 parts by weight

Area resistivity 4 mΩ/□

(Example 9)

(1) A composition comprising 100 parts by weight of aluminum nitride powder (average particle size 1.1 μm), 4 parts by weight of yttria (yttrium oxide, average particle size 0.4 μm), 12 parts by weight of acryl binder and alcohol is granulated by a spray drying method.

(2) The granulated powder is placed in a mold and shaped into a flat plate to obtain a green sheet. The green sheet is drilled to form a through-hole for inserting a support pin for semiconductor wafer and a bottomed hole for embedding a thermocouple.

(3) The green sheet is hot pressed at 1800°C under a pressure of 200 kg/cm$^2$ to obtain an aluminum nitride substrate having a thickness of 3 mm. This is cut out into a disc having a diameter of 210 mm to provide a ceramic substrate 1.

Further, a metal mask is placed on the ceramic substrate 1 and subjected to a sand blast treatment with alumina powder having a diameter of 1 μm to form a groove having a width of 2.4 mm and a depth of 6 μm at a position for forming a heating body.

(4) An electrically conductive paste is printed on the groove of the ceramic substrate 1 of the step (3) by screen printing to form a metal particle layer. The pattern of the metal particle layer is a concentric circle pattern as shown in Fig. 1. As the electrically conductive paste is used Solvest PS 603D, trade name, made by Tokuriki Kagaku Kenkyusho, which is used for the formation of through-hole in a printed wiring board. This electrically conductive paste is a silver/lead paste and contains 7.5 wt% of a metal oxide being a mixture of lead oxide, zinc oxide, silica, boron oxide and alumina (weight ratio of 5/55/10/25/5) per the amount of silver. Moreover, a flake having an average particle size of 4.5 μm is used as silver.

(5) The ceramic substrate provided with the metal particle layer is fired by heating at 780°C to sinter silver and lead in the metal particle layer (electrically conductive paste) and bake onto the ceramic substrate 1. The pattern of the silver-lead sintered body 4 is 5 μm in thickness, 2.4 mm in width and 7.7 mΩ/□ in area resistivity.

(6) The ceramic substrate of the item (5) is immersed in an electroless nickel plating bath comprised of an aqueous solution comprising 80 g/1 of nickel sulfate, 24 g/1 of sodium hypophosphite, 12 g/1 of sodium acetate, 8 g/l of boric acid and 6 g/l of ammonium chloride to precipitate a nickel layer 5 having a thickness of 1 μm on the surface of the silver-lead sintered body 4 to thereby form a heating body.

(7) A silver-lead solder paste is printed on a terminal attaching portion for ensuring connection to a power source by screen printing 1 to form a solder layer (made by Tanaka Kinzoku K.K.) 6. Then, a terminal pin of Kovar is placed on the solder layer 6 and reflowing is carried out by heating at 420°C to fix the terminal pin to the surface of the heating body 2 see Fig. 6).

In this example, the heating body is embedded in the inside of the ceramic substrate but is exposed from the surface thereof as shown in Fig. 6(a). And also, the heating body may be partly embedded in the inside of the ceramic substrate and be at a partly exposed state as shown in Fig. 6(b).

In this example, response time, temperature difference and pull strength are measured likewise Examples 1 and 8. The results are shown in Table 1.

(Comparative Example 3)

The same procedure as in Example 1 is fundamentally repeated except that lead oxide and zinc oxide are added to Solvest PS603D to adjust the amount of the metal oxide to 10 wt%. The area resistivity of the resulting heating body is 50 mΩ/ □ Moreover, time till the confirmation of temperature change after the application of voltage (response time) is measured with respect to Examples 1 to 8 (other than Example 3) and Comparative Examples 1 to 3. And also, the difference between maximum temperature and minimum temperature of the heating face when the surface temperature is 600°C is measured. Moreover, the pull strength (unit kg/2 mm□) is measured at a zone of 2 mm x 2 mm with respect to Examples 1 and 8.

The results are shown in Table 1.

Table 1

|  | Response time (second) | Temperature difference (°C) | Pull strength (kg/2mm□) |
|---|---|---|---|
| Example 1 | 0.5 | 8 | 12.4 |
| Example 2 | 2.0 | 9 | |
| Example 4 | 1.0 | 8 | |
| Example 5 | 1.6 | 15 | |
| Example 6 | 0.8 | 18 | |
| Example 7 | 0.7 | 18 | |
| Example 8 | 0.7 | 18 | 6.0 |
| Example 9 | 0.8 | 9 | 24.0 |
| Comparative Example 1 | 24 | 15 | |
| Comparative Example 2 | 40 | 22 | |
| Comparative Example 3 | 0.8 | 15 | |

INDUSTRIAL APPLICABILITY

As mentioned above, the ceramic heater according to the invention is thin and light and practical and is particularly used for heating and drying semiconductor products in the field of semiconductor industry.

Furthermore, in the ceramic heater according to the invention, the nitride ceramic or carbide ceramic is used as the ceramic substrate and is thinned, so that it is excellent in the temperature followability of heating face against the change of voltage or current and is easy in the temperature control. Moreover, it is excellent in the uniformity of temperature distribution of the heating face and can conduct the efficient drying of the semiconductor product.

**Claims**

1. A ceramic heater comprising a ceramic substrate made of a nitride ceramic or a carbide ceramic and a heating body arranged on a surface thereof.

2. The ceramic heater according to claim 1, wherein the heating body is arranged so as to embed a part thereof in the ceramic substrate.

3. The ceramic heater according to claim 1, wherein the heating body is made of a sintered body of metal particles.

4. The ceramic heater according to claim 1, wherein the heating body is made of a mixture sintered body of metal particles and a metal oxide.

5. The ceramic heater according to claim 1, 2, 3 or 4, wherein as the metal particles is used one or more of noble metal, lead, tungsten, molybdenum and nickel.

6. The ceramic heater according to claim 1, 2, 3, 4 or 5 wherein the heating body is covered on its surface with a non-oxidizing metal layer.

7. The ceramic heater according to claim 1, 2, 3, 4, 5 or 6, wherein the heating body has a sectional shape that an aspect ratio at section (width of heating body/thickness of heating body) is 10-10000.

8. A ceramic heater comprising a ceramic substrate made of the nitride ceramic or carbide ceramic and a flat heating body arranged in an inside thereof and having an aspect ratio at section (width of heating body/thickness of heating body) of 10-10000.

9. A ceramic heater comprising a ceramic substrate made of a nitride ceramic or a carbide ceramic and a flat heating body arranged in an inside thereof, wherein an arranging position of the heating body is a position eccentrically arranged from a center of the substrate in a thickness direction thereof and a face far apart from the heating body is a heating face.

10. The ceramic heater according to claim 8 or 9, wherein the heating body is made of a sintered body of metal particles or electrically conductive ceramic.

11. The ceramic heater according to claim 8 or 9, wherein the heating body is tungsten, molybdenum, tungsten carbide or molybdenum carbide.

12. The ceramic heater according to claim 9, wherein an eccentric degree of the heating body is a position from the heating face of the substrate to more than 50% but less than 100%.

13. The ceramic heater according to claim 9, wherein the heating body has an aspect ratio at section (width of heating body/thickness of heating body) of 10-10000.

14. A method of producing a ceramic heater which comprises at least following steps ①~ ③

   ① step of sintering nitride ceramic powder or carbide ceramic powder to form a substrate made of nitride ceramic or carbide ceramic;
   ② step of printing an electrically conductive paste on the substrate; and
   ③ step of sintering the electrically conductive paste by heating to form a heating body on the surface of the ceramic substrate.

15. The method according to claim 14, wherein the electrically conductive paste used in the step ② is a mixed paste of metal particles and a metal oxide.

16. The method according to claim 14, wherein a metal coating layer is formed by plating a non-oxidizing metal onto the surface of the resulting heating body as a post step of the step ③.

17. A method of producing a ceramic heater which comprises at least following steps ①~ ④:

① step of shaping nitride ceramic powder or carbide ceramic powder to form a green sheet made of nitride ceramic or carbide ceramic;

② step of printing an electrically conductive paste of metal particles alone or a mixture with a metal oxide thereof on the surface of the green sheet made of the nitride ceramic or carbide ceramic;

③ step of laminating the green sheet printed with the electrically conductive paste on one or more of another green sheet obtained by the same treatment as in the step ①; and

④ step of sintering the green sheets and the electrically conductive paste by heating under pressure.

18. The method according to claim 17, wherein when the green sheets obtained by the same treatment as in the step ① are laminated on the upper side and lower side of the green sheet printed with the electrically conductive paste in the step ②, the number ratio of the upper and lower green sheets is within a range of 1/1 to 1/99.

19. An electrically conductive paste for a heating body of a ceramic heater comprising metal particles and a metal oxide.

20. The electrically conductive paste according to claim 19, wherein as the metal particles is used one or more of noble metal, lead, tungsten, molybdenum and nickel.

21. The electrically conductive paste according to claim 19, wherein the metal oxide is one or more of lead oxide, zinc oxide, silicon oxide, boron oxide, aluminum oxide, yttrium oxide and titanium oxide.

22. The electrically conductive paste according to claim 19, wherein the mixture contains not less than 0.1 wt% but less than 10 wt% of the metal oxide to the metal particles.

23. The electrically conductive paste according to claim 19, wherein the metal particle has an average particle size of 0.1-100 μm.

24. The electrically conductive paste according to claim 19, wherein the metal particles are flake-shaped particle or a mixture of spherical particle and flake-shaped particle.

FIG. 1

FIG.2

# FIG.3

# FIG.4

FIG.5a

FIG.5b

FIG.5c

FIG.5d

FIG.6a

FIG.6b

## INTERNATIONAL SEARCH REPORT

| | International application No. |
|---|---|
| | PCT/JP99/03086 |

A. CLASSIFICATION OF SUBJECT MATTER
    Int.Cl$^6$ H05B3/28, H05B3/12

According to International Patent Classification (IPC) or to both national classification and IPC

B. FIELDS SEARCHED

Minimum documentation searched (classification system followed by classification symbols)
    Int.Cl$^6$ H05B3/28, H05B3/12, H05B3/20

Documentation searched other than minimum documentation to the extent that such documents are included in the fields searched
    Jitsuyo Shinan Koho        1940-1996   Toroku Jitsuyo Shinan Koho   1994-1999
    Kokai Jitsuyo Shinan Koho  1971-1999   Jitsuyo Shinan Toroku Koho   1996-1999

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X <br> Y <br><br> A | JP, 8-273815, A (NGK Spark Plug Co., Ltd.), <br> 18 October, 1996 (18. 10. 96), <br> Full text ; Figs. 1, 2 <br> Full text ; Figs. 1, 2 <br><br> Full text ; Figs. 1, 2 (Family: none) | 1-3, 5, 14 <br> 4, 6-8, 10, 11, <br> 15, 16, 20 <br> 9, 12, 13, <br> 22-24 |
| X <br><br> Y | JP, 58-61591, A (Nippondenso Co., Ltd.), <br> 12 April, 1983 (12. 04. 83), <br> Page 2, upper right column, line 18 to lower left <br> column, line 11 <br> Page 2, upper right column, line 18 to lower left <br> column, line 11  &  US, 4449039, A | 19, 21 <br><br> 4, 15, 20 |
| Y | JP, 57-870, A (Matsushita Electric Industrial Co., <br> Ltd.), <br> 5 January, 1982 (05. 01. 82), <br> Page 2, lower left column, line 8 to lower right <br> column, line 2 ; Fig. 2 (Family: none) | 6, 16 |

☒ Further documents are listed in the continuation of Box C.   ☐ See patent family annex.

| | |
|---|---|
| * Special categories of cited documents: <br> "A" document defining the general state of the art which is not considered to be of particular relevance <br> "E" earlier document but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| 6 September, 1999 (06. 09. 99) | 14 September, 1999 (14. 09. 99) |

| Name and mailing address of the ISA/ <br> Japanese Patent Office | Authorized officer |
|---|---|
| Facsimile No. | Telephone No. |

Form PCT/ISA/210 (second sheet) (July 1992)

17

EP 1 109 423 A1

| | INTERNATIONAL SEARCH REPORT | International application No. |
|---|---|---|
| | | PCT/JP99/03086 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP, 6-51658, A  (Toshiba Lighting & Technology Corp.), 25 February, 1994 (25. 02. 94), Par. No. [0019]  (Family: none) | 7, 8, 10, 11 |
| X | JP, 8-273814, A  (NGK Spark Plug Co., Ltd.), 18 October, 1996 (18. 10. 96), Full text ; Figs. 1 to 3  (Family: none) | 17, 18 |

Form PCT/ISA/210 (continuation of second sheet) (July 1992)

18